# EUROPÄISCHE PATENTSCHRIFT

(11) **EP 0 898 714 B1**
(45) Veröffentlichungstag und Bekanntmachung des Hinweises auf die Patenterteilung: **04.12.2002**
(21) Anmeldenummer: 97920577.0
(22) Anmeldetag: 03.04.1997
(51) Int. Cl.: G01R 31/02, G06F 11/273

(54) **BUS-SYSTEM UND VERFAHREN ZUR DIAGNOSE VON ÜBER DAS BUS-SYSTEM MITEINANDER VERBUNDENEN TEILNEHMERN**
BUS SYSTEM AND METHOD OF DIAGNOSING SUBSCRIBERS INTERCONNECTED VIA SAID BUS-SYSTEM
SYSTEME TYPE BUS ET PROCEDE PERMETTANT D'ETABLIR DES DIAGNOSTICS SUR LES POSTES INTERCONNECTES PAR LE BIAIS DU SYSTEME TYPE BUS

(30) Priorität: 14.05.1996 DE 19619441
(43) Veröffentlichungstag der Anmeldung: 03.03.1999
(73) Patentinhaber: GKR Gesellschaft für Fahrzeugklimaregelung mbH, D-71701 Schwieberdingen (DE)
(72) Erfinder: MUNZ, Jürgen, D-70771 Leinfelden (DE); EISENHARDT, Harald, D-71277 Rutesheim (DE)
(74) Vertreter: Behrens, Ralf Holger, Dipl.-Phys.
(86) Internationale Anmeldenummer: DE9700676
(87) Internationale Veröffentlichungsnummer: WO97043657

(56) Entgegenhaltungen:
- EP-A- 0 418 665
- WO-A-84/00834
- WO-A-86/05277
- US-A- 4 862 069
- US-A- 4 951 283

## Beschreibung

### Stand der Technik

Die Erfindung bezieht sich auf ein Bus-System mit über einen Bus miteinander verbundenen Teilnehmern, von denen ein Teilnehmer als Master und die anderen Teilnehmer als Slaves eingerichtet sind, mit einer Diagnoseeinrichtung und ein Verfahren zur Diagnose von über ein Bus-System miteinander verbundenen Teilnehmern, von denen ein Teilnehmer als Master und die anderen Teilnehmer als Slaves arbeiten.

Ein Bus-System bzw. Verfahren dieser Art ist in der WO 90/09631 als bekannt ausgewiesen. Bei diesem bekannten Bus-System und Verfahren wird die Funktion des Datenbusses und/oder die Funktion der Teilnehmer mit Hilfe von Fehlererkennungssignalen in Form von Watch-Dog-Signalen überwacht, und in einem Fehlerfall werden definierte Notlauf-Betriebsarten ergriffen, wobei zwei verschiedene Notlauf-Betriebsarten durchführbar sind.

Bei diesem Fehlererkennungsverfahren werden Signale periodisch wiederkehrend gesendet und empfangen, wobei die am Busverkehr beteiligten Teilnehmer die externen Fehlererkennungssignale innerhalb eines vorgegebenen Zeitrasters erwarten. Eine nähere Fehlerdiagnose ist nicht vorgesehen.

Gemäß der US-A-4 951 283 weist eine Vielzahl von elektronischen Logikschaltungen zumindest einen Ausgang aus, der mit einem Bussystem verbunden ist. Ein automatisches Testgerät dient der Erfassung fehlerhafter Betriebszustände sowohl der elektronischen Logikschaltungen als auch des Bussystems. Hierzu werden Testsignale an die elektronischen Schaltungen geschickt und die resultierenden Spannungen und Ströme zur Diagnose ausgewertet. Eine im Testgerät erzeugte Versorgungsspannung wird direkt dem Bus zugeführt. Zu Beginn der Testsequenz werden Signale an alle enable-Eingänge der elektronischen Logikschaltungen geschickt.

Bei der EP-A-0 418 665 erfolgt die Diagnose der Verbraucher nicht in dem Hauptcomputer, sondern in Kontrollschaltungen. In Abhängigkeit von den in den jeweiligen Kontrollschaltungen diagnostizierten Zuständen der Last geben die Kontrollschaltungen eine Signalfolge aus, die dem Hauptcomputer den diagnostizierten Zustand der jeweiligen Last bzw. deren Stromversorgung mitteilt. Hierzu ist jedoch jeder Last eine Diagnoseschaltung zugeordnet.

Der Erfindung liegt die Aufgabe zugrunde, ein Bus-System bzw. ein Verfahren der eingangs genannten Art bereitzustellen, bei dem auf einfache Weise unterschiedliche Diagnosemöglichkeiten der Ausgänge der Teilnehmer gegeben sind.

Diese Aufgabe wird mit den Merkmalen der Ansprüche 1 bzw. 3 gelöst.

Die Erfindung betrifft ein Bus-System mit über einen Bus miteinander verbundenen Teilnehmern, von denen ein Teilnehmer als Master und die anderen Teilnehmer als Slaves eingerichtet sind, mit einer lediglich in dem Master befindlichen Diagnoseeinrichtung, wobei in der Diagnoseeinrichtung Strom- und/oder Spannungsdaten von mindestens einem zu diagnostizierenden Ausgang mindestens eines Slaves gespeichert sind und wobei auf der Grundlage eines in dem Master gespeicherten Programms die Diagnose zumindest des zu diagnostizierenden Ausgangs unter vorgegebenen oder vorgebbaren Bedingungen durchführbar ist, wobei die Diagnose auf der Grundlage der gespeicherten Strom- und/oder Spannungsdaten und dem erfaßten Strom- oder Spannungszustand durchführbar ist, dadurch gekennzeichnet, daß die Diagnoseeinrichtung den über die Busversorgung zugeführten an dem zu diagnostizierenden Ausgang vorliegenden Strom- oder Spannungszustand erfaßt, daß für die Diagnose eines Kurzschlusses oder einer Unterbrechung in den Slaves das Bus-System mit den Slaves und deren Ausgängen in einen definierten Zustand schaltbar ist, wobei es sich bei dem zu diagnostizierenden Ausgang und den in einen definierten Zustand geschalteten Ausgänge um an die Busversorgung angeschlossene Ausgänge handelt.

Weiterhin ist vorgesehen ein Verfahren zur Diagnose von über ein Bus-System miteinander verbundenen Teilnehmern, von denen ein Teilnehmer als Master und die anderen Teilnehmer als Slaves arbeiten, wobei die Diagnose im Master vorgenommen wird, wobei zur Diagnose zu einer vorgegebenen oder vorgebbaren Zeit eine Diagnosebetriebsart gestartet wird, wobei die Ausgänge aller Slaves gemäß einem in dem Master vorhandenen Programm in vorgegebene Zustände geschaltet werden, dadurch gekennzeichnet, daß bei den vorgegebenen Zuständen die zu diagnostizierenden Ausgänge nacheinander hinsichtlich eines Kurzschlusses oder einer Unterbrechung in den Slaves abgefragt werden, indem der an dem zu diagnostizierenden Ausgang vorliegende Strom- oder Spannungswert in dem Master erfaßt wird und die Diagnose auf der Grundlage in dem Master gespeicherter Strom- und/oder Spannungsdaten und dem erfaßten Strom- oder Spannungszustand durchgeführt wird, wobei es sich bei dem zu diagnostizierenden Ausgang und den in einen definierten Zustand geschalteten Ausgänge um an die Busversorgung angeschlossene Ausgänge handelt.

Mit diesen Maßnahmen kann die Diagnose der Teilnehmer bei einfachem Aufbau hinsichtlich unterschiedlicher Fehler durchgeführt werden, so daß Aussagen zur Fehlerart getroffen und darauf abgestimmte Fehlerstrategien durchgeführt werden können. Der Aufwand für die Diagnoseeinrichtung und die damit verbundenen Kosten werden im gesamten Bus-System nur einmal für den Master fällig.

Ist vorgesehen, daß für die Diagnose eines Kurzschlusses oder einer Unterbrechung das Bussystem mit den Teilnehmern und deren Ausgängen in einen definierten Zustand schaltbar ist, wobei der an dem zu diagnostizierenden Ausgang vorliegende Strom- oder Spannungszustand erfaßbar ist, und daß die Diagnose auf der Grundlage der gespeicherten Stromund/Oder Spannungsdaten und dem erfaßten Strom- oder Spannungszustand durch-führbar ist, so kann eine differenzierte Aussage darüber gemacht werden, ob an einem betreffenden Ausgang ein Kurzschluß oder eine Unterbrechung festgestellt worden ist, wobei es die in der Diagnoseeinrichtung gespeicher-ten Daten zulassen, den Grad eines Kurzschlusses oder einer Unterbrechung zu ermitteln und darauf eine entsprechende Fehlerstrategie abzustimmen. Beispielsweise kann auf diese Weise festgestellt werden, ob nur ein Teil einer Wicklung eines Schrittmotors fehlerhaft ist.

Die Diagnosemaßnahmen können vorteilhaft mit einem Aufbau durchgeführt werden, bei dem die Diagnoseeinrichtung eine umschaltbare Widerstandseinrichtung und/oder einen umschaltbaren Meßverstärker aufweist.

Ist bei dem Verfahren vorgesehen, daß nach dem Start der Diagnosebetriebsart alle Teilnehmer in den Zustand geringster Stromaufnahme gefahren werden, wobei eine Zustandsänderung der Teilnehmer außer des zu diagnostizierenden Ausganges verhindert wird, so liegt zur Durchführung der Diagnose ein eindeutiger Zustand des Bus-Systems vor, so daß Fehler zuverlässig erkannt werden können.

Vorteilhaft ist die Vorgehensweise derart, daß der Strommeßbereich einer im Master vorgesehenen Diagnoseeinrichtung zum Feststellen eines Kurzschlusses möglichst groß bzw. eine Verstärkung möglichst klein gewählt wird, daß dann in einem Slave der zu diagnostizierende Ausgang eingeschaltet wird und daß bei Überschreitung eines festgelegten Stromes für diesen Ausgang Kurzschluß diagnostiziert wird. Mit diesen Maßnahmen wird die Diagnoseeinrichtung bei einem tatsächlich vorhandenen Kurzschluß und einem dabei auftretenden hohen Strom vor der Gefahr einer Beschädigung gewahrt, während anschließend der Meßbereich verkleinert werden kann, um einen nicht vollkommenen Kurzschluß festzustellen.

Ist weiterhin vorgesehen, daß zum Feststellen einer Unterbrechung der Strommeßbereich im Master verkleinert bzw. die Verstärkung vergrößert wird, daß anschließend der zu diagnostizierende Ausgang abgeschaltet wird und daß bei Unterschreitung einer festgelegten kleinsten Stromänderung eine Unterbrechung diagnostiziert wird, so wird eine für die Erkennung einer Unterbrechung geeignete Empfindlichkeit erzielt, wobei die Empfindlichkeit zur Erkennung unterschiedlicher Grade der Unterbrechung stufenweise gesteigert werden kann.

Ist weiterhin die Vorgehensweise derart, daß die Kurzschlußdiagnose und die Unterbrechungsdiagnose an allen zu diagnostizierenden Ausgängen in dieser Reihenfolge nacheinander vorgenommen werden, wobei die Unterbrechungsdiagnose nur durchgeführt wird, wenn an demselben Ausgang zuvor kein Kurzschluß diagnostiziert worden ist, und daß die Diagnose beendet wird, wenn alle zu diagnostizierenden Ausgänge untersucht sind, so wird eine systematische Diagnose der zu untersuchenden Ausgänge auf Kurzschluß und Unterbrechung ermöglicht.

Für den Fall, daß ein Fehler festgestellt wird, sind die Maßnahmen vorteilhaft, daß bei Feststellen eines Kurzschlusses in der Diagnoseeinrichtung ein Fehlereintrag vorgenommen und eine programmierte Kurzschlußstrategie durchgeführt wird und daß bei Feststellen einer Unterbrechung in der Diagnoseeinrichtung ein Fehlereintrag und eine programmierte Unter-brechungsstrategie durchgeführt wird.

### Zeichnung

Die Erfindung wird nachfolgend anhand eines Ausführungsbeispiels unter Bezugnahme auf die Zeichnungen näher erläutert. Es zeigen:
- Fig. 1: ein Bus-System mit daran angeschlossenen Teilnehmern und
- Fig. 2: ein Ablaufdiagramm bei einer Diagnose des Bus-Systems.

### Beschreibung des Ausführungsbeispiels

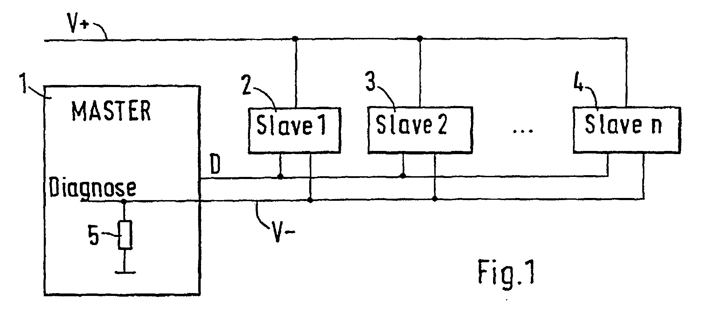

Das in Fig. 1 dargestellte Bus-System weist einen Bus mit einer Datenleitung D sowie einer Busversorgung V+, V- auf. An den Bus sind als Teilnehmer ein Master 1 sowie Slaves 2,3,4 angeschlossen.

In dem Master 1 ist eine Diagnoseeinrichtung 5 für die Teilnehmer 1,2,3,4 vorgesehen. Wie aus der Fig. 1 ersichtlich, können entsprechend der physikalischen Möglichkeiten des Bus-Systems eine wählbare Anzahl n von Slaves vorgesehen sein.

Die Diagnoseeinrichtung ist symbolisch als Widerstand gezeichnet, wobei darunter eine geeignete Meßeinrichtung mit einer geeigneten Widerstandsanordnung bzw. einem Meßverstärker zu verstehen ist. Die Diagnoseeinrichtung 5 weist ferner einen (nicht gezeigten) Analog/Digital-Wandler auf. Die Diagnoseeinrichtung 5 ist zum Erfassen von Kurzschlüssen und/oder Unterbrechungen an einigen oder allen Ausgängen einiger oder aller Slaves ausgebildet, wozu die Diagnoseeinrichtung 5 mit einer Strom- bzw. Spannungsmeßeinrichtung ausgestattet ist.

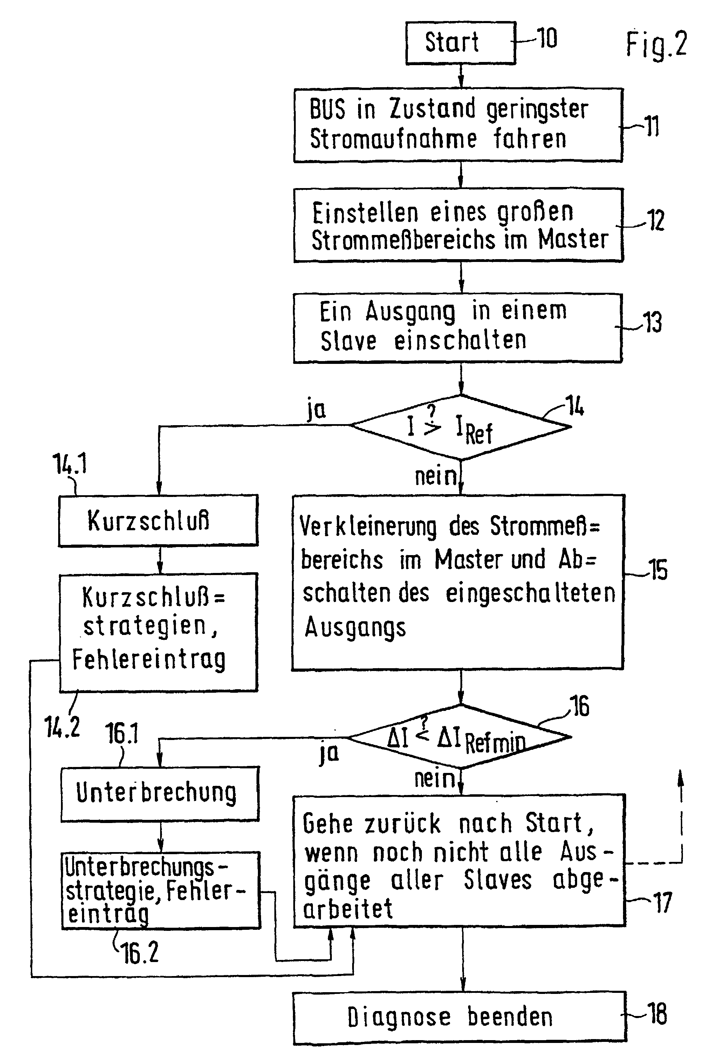

Fig. 2 zeigt ein Ablaufdiagramm für eine Diagnose. Über ein Programm bzw. Protokoll werden nach einem Start 10 in einem Schritt 11 alle Slaves 2,3,4 in den Zustand geringstmöglicher Stromaufnahme gefahren, um eine möglichst große Stromauflösung zu ermöglichen. Eine Änderung der Zustände des Bus-Systems ist bei der auf diese Weise gewählten Diagnosebetriebsart unterbunden. Lediglich ein jeweiliger zu untersuchender Ausgang kann geschaltet werden. In diesem Zustand geringstmöglicher Stromaufnahme ist die Gesamt stromaufnahme des Busses konstant, z.B. in einem Bereich zwischen 150 mA und 250 mA. Dieser Wert ist der Diagnoseeinrichtung bekannt. Bei diesen definierten Ausgangsbedingungen ist die Kurzschluß- bzw. Unterbrechungsdiagnose von Aktuatoren (z.B. Schaltausgänge, Motorwicklungen usw.) zuverlässig durch-führbar.

Zur Durchführung der Kurzschlußdiagnose wird in einem Schritt 12 in der Diagnoseeinrichtung ein möglichst großer Strommeßbereich bzw. eine möglichst kleine Verstärkung gewählt. Durch eine Busnachricht schaltet der Master 1 in einem Schritt 13 in genau einem Slave genau einen Ausgang ein, dessen Adresse in dem Master 1 ebenfalls bekannt ist. Bei Überschreitung eines fest-gelegten Stroms wird in einem Schritt 14 Kurzschluß diagnostiziert, da ein regulärer Strom des betreffenden Ausgangs in der Diagnoseeinrichtung 5 ebenfalls gespeichert ist. Beträgt z.B. der Strom in der Bus-Ruhe 200 mA und der reguläre Strom an dem betreffenden Ausgang, z.B. einer Schrittmotorwicklung 250 mA, so kann der festgelegte Strom I_{Ref} z.B. deutlich oberhalb der Summe des Ruhestroms und des regulären Stroms, beispielsweise bei 800 mA gewählt werden.

Bei abgestuften festgelegten Werten des Stroms und schrittweise verringerten Strommeßbereichen bzw. schrittweise vergrößerter Verstärkung kann der Grad des Kurzschlusses näher ermittelt werden. Wird in dem Schritt 14 festgestellt, daß der festgelegte Strom I_{Ref} überschritten wird, so wird in einem Schritt 14.1 Kurzschluß diagnostiziert. Daraufhin können in einem Schritt 14.2 ein Fehlereintrag und gewünschtenfalls geeignete Kurzschlußstrategien erfolgen. Ist z.B. kein vollkommener, sondern nur ein teilweiser Kurzschluß diagnostiziert worden, so kann der entsprechende Ausgang des entsprechenden Slaves in größeren Zeitabständen für kürzere Zeit und/oder mit geringerer Leistung betrieben werden.

Wird in dem Schritt 14 keine Überschreitung des festgelegten Stromes I_{Ref} diagnostiziert, und sind gegebenenfalls mehrere Strommeßbereiche bzw. Verstärkungspegel abgearbeitet, so wird in einem Schritt 15 zur Unterbrechnungsdiagnose desselben Ausganges übergegangen und der Strommeßbereich in der Diagnoseeinrichtung 5 verkleinert bzw. die Verstärkung erhöht. Der während der Kurzschlußdiagnose eingeschaltete Ausgang wird abgeschaltet. Wird in einem Schritt 16 eine festgelegte kleinste Stromänderung ΔI_{Refmin} unterschritten, so wird eine Unterbrechung diagnostiziert. Auch die kleinste Stromänderung Δ I_{Refmin} und der reguläre Strom bei abgeschaltetem, fehlerfreiem betreffendem Eingang sind in der Diagnoseeinrichtung 5 bekannt, so daß die Stromänderung infolge der Unterbrechung festgestellt wird. Auch hierbei können durch Abstufung der Strommeßbereiche bzw. des Verstärkungspegels genauere Messungen des Grades der Unterbrechung festgestellt werden.

Wird eine Unterbrechung diagnostiziert, d.h. die kleinste festgelegte Stromänderung Δ I_{Refmin} unterschritten, so wird nach einem die Unterbrechung diagnostizierenden Schritt 16.1 in einem Schritt 16.2 ein Fehlereintrag und gegebenenfalls eine gewünschte Unterbrechungstrategie durchgeführt, die ebenfalls nach dem Grad der Unterbrechung gewählt werden kann.

In jedem Fall, d.h. bei Feststellen eines Kurzschlusses oder einer Unterbrechung oder keines Fehlers, wird in einem Schritt 17 der Diagnosevorgang neu gestartet bis alle zu untersuchenden Ausgänge abgearbeitet sind. Danach wird in einem Schritt 18 die Diagnose beendet.

Geeignete Situationen, in denen die Diagnosebetriebsart durchgeführt wird, sind z.B. die Inbetriebnahme des Bus-Systems, vor Abschalten des Bus-Systems oder eine Testsituation in einer Werkstatt bzw. durch Wartungspersonal. Auch bei Auftreten eines Fehlers in dem Bus-System kann es vorteilhaft sein, über ein vorgegebenes Programm die Diagnosebetriebsart zu starten.

Aufgrund der eingetragenen Fehler kann im Laufe der Zeit auch festgestellt werden, ob ein Kurzschluß bzw. eine Unterbrechung dauerhaft vorliegt oder nur vorübergehend aufgetreten war.

Das beschriebene Bus-System bzw. Verfahren zur Diagnose ist vorteilhaft bei Kraftfahrzeugen anwendbar.

## Patentansprüche

1. Bus-System mit über einen Bus miteinander verbundenen Teilnehmern, von denen ein Teilnehmer als Master (1) und die anderen Teilnehmer als Slaves (2, 3, 4) eingerichtet sind, mit einer lediglich in dem Master (1) befindlichen Diagnoseeinrichtung (5), wobei in der Diagnoseeinrichtung (5) Strom- und/oder Spannungsdaten von mindestens einem zu diagnostizierenden Ausgang mindestens eines Slaves (2, 3, 4) gespeichert sind und wobei auf der Grundlage eines in dem Master (1) gespeicherten Programms die Diagnose zumindest des zu diagnostizierenden Ausgangs unter vorgegebenen oder vorgebbaren Bedingungen durchführbar ist, wobei die Diagnose auf der Grundlage der gespeicherten Strom- und/oder Spannungsdaten und dem erfaßten Strom- oder Spannungszustand durchführbar ist, **dadurch gekennzeichnet, daß** die Diagnoseeinrichtung (5) den über die Busversorgung (v-) zugeführten an dem zu diagnostizierenden Ausgang vorliegenden Strom- oder Spannungszustand erfaßt, daß für die Diagnose eines Kurzschlusses oder einer Unterbrechung in den Slaves (2, 3, 4) das Bus-System mit den Slaves (2, 3, 4) und deren Ausgängen in einen definierten Zustand schaltbar ist, wobei es sich bei dem zu diagnostizierenden Ausgang und die in einen definierten Zustand geschalteten Ausgänge um an die Busversorgung (v-) angeschlossene Ausgänge handelt.

2. Bus-System nach Anspruch 1, **dadurch gekennzeichnet, daß** die Diagnoseeinrichtung (5) eine umschaltbare Meßwiderstandseinrichtung und/oder einen umschaltbaren Meßverstärker aufweist.

3. Verfahren zur Diagnose von über ein Bus-System miteinander verbundenen Teilnehmern, von denen ein Teilnehmer als Master (1) und die anderen Teilnehmer als Slaves (2, 3, 4) arbeiten, wobei die Diagnose im Master (1) vorgenommen wird, wobei zur Diagnose zu einer vorgegebenen oder vorgebbaren Zeit eine Diagnosebetriebsart gestartet wird, wobei die Ausgänge aller Slaves (2, 3, 4) gemäß einem in dem Master (1) vorhandenen Programm in vorgegebene Zustände geschaltet werden, **dadurch gekennzeichnet, daß** bei den vorgegebenen Zuständen die zu diagnostizierenden Ausgänge nacheinander hinsichtlich eines Kurzschlusses oder einer Unterbrechung in den Slaves (2, 3, 4) abgefragt werden, indem der an dem zu diagnostizierenden Ausgang und über die Busversorgung (v-) dem Master zugeführte vorliegende Strom- oder Spannungswert in dem Master (1) erfaßt wird und die Diagnose auf der Grundlage in dem Master (1) gespeicherter Strom- und/oder Spannungsdaten und dem erfaßten Strom- oder Spannungszustand durchgeführt wird, wobei es sich bei dem zu diagnostizierenden Ausgang und die in einen definierten Zustand geschalteten Ausgänge um an die Busversorgung (v-) angeschlossene Ausgänge handelt.

4. Verfahren nach Anspruch 3, **dadurch gekennzeichnet, daß** nach dem Start der Diagnosebetriebsart alle Teilnehmer (2, 3, 4) in den Zustand geringster Stromaufnahme gefahren werden, wobei eine Zustandsänderung der Teilnehmer (2, 3, 4) außer des zu diagnostizierenden Ausgangs verhindert wird.

5. Verfahren nach Anspruch 3 oder 4, **dadurch gekennzeichnet, daß** der Strommeßbereich einer im Master (1) vorgesehenen Diagnoseeinrichtung (5) zum Feststellen eines Kurzschlusses möglichst groß bzw. eine Verstärkung möglichst klein gewählt wird, daß dann in einem Slave (2, 3, 4) der zu diagnostizierende Ausgang eingeschaltet wird und daß bei Überschreitung eines festgelegten Stromes für diesen Ausgang Kurzschluß diagnostiziert wird.

6. Verfahren nach einem der Ansprüche 3 bis 5, **dadurch gekennzeichnet, daß** zum Feststellen einer Unterbrechung der Strommeßbereich im Master (1) verkleinert bzw. die Verstärkung vergrößert wird, daß anschließend der zu diagnostizierende Ausgang abgeschaltet wird und daß bei Unterschreitung einer festgelegten kleinsten Stromänderung eine Unterbrechung diagnostiziert wird.

7. Verfahren nach den Ansprüchen 5 und 6, **dadurch gekennzeichnet, daß** die Kurzschlußdiagnose und die Unterbrechungsdiagnose an allen zu diagnostizierenden Ausgängen in dieser Reihenfolge nacheinander vorgenommen werden, wobei die Unterbrechungsdiagnose nur durchgeführt wird, wenn an demselben Ausgang zuvor kein Kurzschluß diagnostiziert worden ist, und daß die Diagnose beendet wird, wenn alle zu diagnostizierenden Ausgänge untersucht sind.

8. Verfahren nach einem der Ansprüche 3 bis 7, **dadurch gekennzeichnet, daß** bei Feststellen eines Kurzschlusses in der Diagnoseeinrichtung (5) ein Fehlereintrag vorgenommen und eine programmierte Kurzschlußstrategie durchgeführt wird und daß bei Feststellen einer Unterbrechung in der Diagnoseeinrichtung (5) ein Fehlereintrag und eine programmierte Unterbrechungsstrategie durchgeführt wird.

## Claims

1. Bus system having subscribers which are connected to one another via a bus, one subscriber of which is set up as a master (1) and the other subscribers of which are set up as slaves (2, 3, 4), having a diagnostic device (5) which is located only in the master (1), current data and/or voltage data from at least one output to be diagnosed, of at least one slave (2, 3, 4) being stored in the diagnostic device (5), and it being possible to carry out the diagnosis at least of the output to be diagnosed under predefined or predefinable conditions on the basis of a programme stored in the master (1), it being possible to carry out the diagnosis on the basis of the stored current data and/or voltage data and the sensed current state and/or voltage state, **characterized in that** the diagnostic device (5) senses the current state or voltage state which is fed via the bus supply (v-) and is present at the output to be diagnosed, **in that**, for the diagnosis of a short-circuit or a break in the slaves (2, 3, 4), the bus system with the slaves (2, 3, 4) and their outputs can be switched into a defined state, the output which is to be diagnosed and the outputs which are switched into a defined state being outputs which are connected to the bus supply (v-).

2. Bus system according to Claim 1, **characterized in that** the diagnostic device (5) has a switchable measuring resistor device and/or a switchable measuring amplifier.

3. Method for diagnosing subscribers which are connected via a bus system, one subscriber of which operating as a master (1) and the other subscribers operating as slaves (2, 3, 4), the diagnosis being performed in the master (1), the diagnostic operating mode being started in order to diagnose, at a predefined or predefinable time, the outputs of all the slaves (2, 3, 4) being switched into predefined states according to a programme which is present in the master (1), **characterized in that** in the predefined states the outputs which are to be diagnosed are successively interrogated with respect to a short-circuit or a break in the slaves (2, 3, 4) **in that** the present current value or voltage value which is fed to the output to be diagnosed and to the master via the bus supply (v-) is sensed in the master (1) and the diagnosis is carried out on the basis of current data and/or voltage data stored in the master (1) and the sensed current state or voltage state, the output which is to be diagnosed and the outputs which are switched into a defined state being outputs which are connected to the bus supply (v-).

4. Method according to Claim 3, **characterized in that**, after the start of the diagnostic operating mode, all the subscribers (2, 3, 4) are changed into the state of minimum power drain, a change in state of the subscribers (2, 3, 4) except of the output which is to be diagnosed being prevented.

5. Method according to Claim 3 or 4, **characterized in that** the current measuring range of a diagnostic device (5) provided in the master (1) should be selected to be as large as possible, or the minimum amplification should be selected, in order to detect a short-circuit, **in that** the output which is to be diagnosed is then switched on in a slave (2, 3, 4), and **in that**, when a current which is detected for this output is exceeded, a short-circuit is diagnosed.

6. Method according to one of Claims 3 to 5, **characterized in that**, in order to detect a break, the current measuring range in the master (1) is reduced and the amplification is enlarged, **in that** the output which is to be diagnosed is then switched off, and **in that**, when a defined minimum change in current is undershot, a break is diagnosed.

7. Method according to Claims 5 and 6, **characterized in that** the short-circuit diagnosis and the break diagnosis at all the outputs to be diagnosed are performed successively in this sequence, the break diagnosis being carried out only if no short-circuit has previously been diagnosed at the same output, and **in that** the diagnosis is terminated when all the outputs to be diagnosed have been examined.

8. Method according to one of Claims 3 to 7, **characterized in that**, when a short-circuit is detected in the diagnostic device (5), an error entry is made and a programmed short-circuit strategy is carried out, and **in that**, when a break is detected in the diagnostic device (5), an error entry and a programmed interrupt strategy are carried out.

## Revendications

1. Système de bus comportant des postes reliés par un bus dont l'un est un poste maître (1) et les autres des postes esclaves (2, 3, 4), comprenant uniquement une installation de diagnostic (5) installée dans le poste maître (1), l'installation de diagnostic (5) contenant des données de courant et/ou de tension d'au moins une sortie à diagnostiquer d'au moins un esclave (2, 3, 4), et dans lequel
sur la base d'un programme enregistré dans le poste maître (1) on effectue le diagnostic au moins de la sortie à diagnostiquer dans des conditions prédéterminées ou susceptibles de l'être,
le diagnostic étant effectué sur la base des données de courant et/ou de tension mémorisées et de l'état de courant ou de tension saisi,
**caractérisé en ce que**
l'installation de diagnostic (5) saisit l'état de courant ou de tension fourni par l'alimentation de bus (v-) à la sortie à diagnostiquer,
pour le diagnostic d'un court-circuit ou d'une coupure dans les postes esclaves (2, 3, 4) on commute le système de bus avec les postes esclaves (2, 3, 4) et leurs sorties dans un état défini,
la sortie à diagnostiquer et les sorties branchées dans un état défini étant les sorties reliées à l'alimentation de bus (v-).

2. Système de bus selon la revendication 1,
**caractérisé en ce que**
l'installation de diagnostic (5) comporte une installation de mesure de résistance et/ou un amplificateur de mesure commutable.

3. Procédé de diagnostic de poste relié par un système de bus dont l'un est un poste maître (1) et les autres des postes esclaves (2, 3, 4), le diagnostic étant effectué dans le poste maître (1), selon lequel
pour le diagnostic on démarre à un instant donné ou pendant une durée donnée, un mode de fonctionnement de diagnostic, les sorties de tous les postes esclaves (2, 3, 4) étant branchées dans des états prédéterminés existant dans le programme du poste maître (1),
**caractérisé en ce que**
pour les états prédéterminés, on interroge les sorties à diagnostiquer successivement pour déterminer un court-circuit ou une coupure dans les postes esclaves (2, 3, 4) saisissant la valeur de courant ou de tension à la sortie à diagnostiquer et fournie par l'alimentation de bus (v-) au poste maître (1), on effectue le diagnostic sur la base des données de courant et/ou de tension enregistrées dans le poste maître (1) et de l'état de courant ou de tension saisi,
la sortie à diagnostiquer et les sorties à brancher dans un état défini étant les sorties branchées sur l'alimentation de bus (v-).

4. Procédé selon la revendication 3,
**caractérisé en ce qu'**
après le départ du mode de fonctionnement de diagnostic, tous les postes (2, 3, 4) sont mis dans l'état de consommation de courant la plus faible et on interdit une variation d'état des postes (2, 3, 4) à l'exception de la sortie à diagnostiquer.

5. Procédé selon l'une quelconque des revendications 3 ou 4,
**caractérisé en ce que**
la plage de mesure de courant dans l'installation de diagnostic (5) prévue dans le poste maître (1) pour déterminer un court-circuit est aussi grande que possible ou correspond à une amplification aussi faible que possible, et ensuite dans l'un des postes esclaves (2, 3, 4) on branche la sortie à diagnostiquer et en cas de dépassement d'un courant fixé pour cette sortie on diagnostique un court-circuit.

6. Procédé selon l'une quelconque des revendications 3 à 5,
**caractérisé en ce que**
pour constater une coupure on diminue la plage de mesure de courant dans le poste maître (1) ou on augmente l'amplification, et ensuite on coupe la sortie à diagnostiquer et en cas de dépassement vers le bas d'une variation de courant plus faible fixée on diagnostique une coupure.

7. Procédé selon l'une quelconque des revendications 5 et 6,
**caractérisé en ce que**
le diagnostic de court-circuit et le diagnostic de coupure sont effectués sur toutes les sorties à diagnostiquer dans cet ordre, le diagnostic de coupure n'étant exécuté que si à la même sortie il n'a pas été diagnostiqué précédemment un court-circuit, et on termine le diagnostic lorsque toutes les sorties à diagnostiquer ont été examinées.

8. Procédé selon l'une quelconque des revendications 3 à 7,
**caractérisé en ce que**
si on constate un court-circuit dans l'installation de diagnostic (5), on enregistre un défaut et on effectue une stratégie de court-circuit, programmée, et si on constate une coupure dans l'installation de diagnostic (5) on effectue un enregistrement d'erreur et une stratégie de coupure programmée.
